(19) Europäisches Patentamt
European Patent Office
Office européen des brevets

(11) **EP 2 234 141 A1**

(12) **EUROPEAN PATENT APPLICATION**
published in accordance with Art. 153(4) EPC

(43) Date of publication:
**29.09.2010 Bulletin 2010/39**

(51) Int Cl.:
**H01L 21/027** (2006.01)          **G02B 19/00** (2006.01)
**G02B 26/08** (2006.01)          **G03F 7/20** (2006.01)

(21) Application number: **08861567.9**

(22) Date of filing: **04.11.2008**

(86) International application number:
**PCT/JP2008/070000**

(87) International publication number:
**WO 2009/078224 (25.06.2009 Gazette 2009/26)**

(84) Designated Contracting States:
**AT BE BG CH CY CZ DE DK EE ES FI FR GB GR HR HU IE IS IT LI LT LU LV MC MT NL NO PL PT RO SE SI SK TR**
Designated Extension States:
**AL BA MK RS**

(30) Priority: **17.12.2007 JP 2007324114**

(71) Applicant: **Nikon Corporation**
**Tokyo 100-8331 (JP)**

(72) Inventors:
• **TANITSU, Osamu**
  **Tokyo 100-8331 (JP)**
• **KITA, Naonori**
  **Tokyo 100-8331 (JP)**

(74) Representative: **HOFFMANN EITLE**
**Patent- und Rechtsanwälte**
**Arabellastrasse 4**
**81925 München (DE)**

(54) **ILLUMINATION OPTICAL SYSTEM, EXPOSURE APPARATUS, AND DEVICE MANUFACTURING METHOD**

(57)     An illumination optical system achieves a desired pupil intensity distribution, for example, while suppressing influence of a diffraction blur of a diffraction image formed on an illumination pupil by reflected light from microscopic mirror elements arranged regularly. The illumination optical system (IL) which illuminates an illumination target surface (M) on the basis of light from a light source (1) is provided with a spatial light modulator (3a) having a plurality of optical elements arrayed two-dimensionally and being individually controllable, a distribution forming optical system (4, 5) which forms a predetermined light intensity distribution on an illumination pupil on the basis of light having traveled via the spatial light modulator, and a control unit (CR) which integrally controls postures of a group of optical elements according to a shape of the predetermined light intensity distribution formed on the illumination pupil.

**Fig.1**

EP 2 234 141 A1

## Description

### TECHNICAL FIELD

The present invention relates to an illumination optical system, an exposure apparatus, and a device manufacturing method. More particularly, the present invention relates to an illumination optical system suitably applicable to an exposure apparatus for manufacturing such devices as semiconductor devices, imaging devices, liquid crystal display devices, and thin film magnetic heads by lithography.

### BACKGROUND ART

In a typical exposure apparatus of this type, a light beam emitted from a light source travels through a fly's eye lens as an optical integrator to form a secondary light source (a predetermined light intensity distribution on an illumination pupil in general) as a substantial surface illuminant consisting of a large number of light sources. The light intensity distribution on the illumination pupil will be referred to hereinafter as a "pupil intensity distribution." The illumination pupil is defined as a position such that an illumination target surface becomes a Fourier transform plane of the illumination pupil by action of an optical system between the illumination pupil and the illumination target surface (a mask or a wafer in the case of the exposure apparatus).

Beams from the secondary light source are condensed by a condenser lens to superposedly illuminate the mask on which a predetermined pattern is formed. Light passing through the mask travels through a projection optical system to be focused on the wafer, whereby the mask pattern is projected (or transferred) onto the wafer to effect exposure thereof. Since the pattern formed on the mask is a highly integrated one, an even illuminance distribution must be obtained on the wafer in order to accurately transfer this microscopic pattern onto the wafer.

There is a hitherto proposed illumination optical system capable of continuously changing the pupil intensity distribution (and, in turn, an illumination condition) without use of a zoom optical system (cf. Patent Document 1). In the illumination optical system disclosed in Patent Document 1, using a movable multi-mirror composed of a large number of microscopic mirror elements which are arranged in an array form and an inclination angle and inclination direction of each of which are individually driven and controlled, an incident beam is divided in microscopic units by respective reflecting surfaces to be deflected thereby, so as to convert a cross section of the incident beam into a desired shape or desired size and, in turn, so as to realize a desired pupil intensity distribution.

Patent Document 1: Japanese Patent Application Laid-open No. 2002-353105

### DISCLOSURE OF THE INVENTION

### Problem to be Solved by the Invention

Since the illumination optical system described in Patent Document 1 uses the large number of microscopic mirror elements whose postures are individually controlled, degrees of freedom are high about change in shape and size of the pupil intensity distribution. However, the illumination optical system causes a phenomenon in which a tail of a light intensity distribution of a diffraction image formed on the illumination pupil by reflected light from one of the microscopic mirror elements arrayed regularly spreads out of a region corresponding to the mirror element to extend relatively largely, i.e., a diffraction blur, and it is thus sometimes difficult to form a desired pupil intensity distribution because of influence of the diffraction blur.

The present invention has been accomplished in view of the above problem and it is an object of the present invention to provide an illumination optical system capable of achieving a desired pupil intensity distribution, for example, while suppressing the influence of the diffraction blur of diffraction images formed on the illumination pupil by reflected light from the microscopic mirror elements arranged regularly. It is another object of the present invention to provide an exposure apparatus capable of performing excellent exposure under an appropriate illumination condition, using the illumination optical system achieving the desired pupil intensity distribution while suppressing the influence of the diffraction blur.

### Means for Solving the Problem

In order to solve the problem, a first aspect of the present invention provides an illumination optical system which illuminates an illumination target surface on the basis of light from a light source, the illumination optical system comprising:

a spatial light modulator having a plurality of optical elements arrayed two-dimensionally and being individually controllable;

a distribution forming optical system which forms a predetermined light intensity distribution on an illumination pupil of the illumination optical system on the basis of light having traveled via the spatial light modulator; and

a control unit which integrally controls postures of a group of optical elements according to a shape of the predetermined light intensity distribution formed on the illumination pupil, out of the plurality of optical elements.

A second aspect of the present invention provides an exposure apparatus comprising the illumination optical system of the first aspect for illuminating a predetermined pattern, wherein the predetermined pattern is transferred onto a photosensitive substrate to effect exposure thereof.

A third aspect of the present invention provides a device manufacturing method comprising:

an exposure step of transferring the predetermined pattern onto the photosensitive substrate to effect exposure thereof, using the exposure apparatus of the second aspect;

a development step of developing the photosensitive substrate on which the predetermined pattern is transferred, to form a mask layer of a shape corresponding to the predetermined pattern on a surface of the photosensitive substrate; and

a processing step of processing the surface of the photosensitive substrate through the mask layer.

A fourth aspect of the present invention provides a control method of a spatial light modulator having a plurality of optical elements arrayed two-dimensionally and being individually controllable, the control method being a method for controlling the spatial light modulator used in an illumination optical system which forms a predetermined light intensity distribution on an illumination pupil on the basis of light from a light source having traveled via the spatial light modulator and which illuminates an illumination target surface on the basis of the light having traveled via the illumination pupil, the control method of the spatial light modulator comprising integrally controlling postures of a group of optical elements according to a shape of the predetermined light intensity distribution formed on the illumination pupil, out of the plurality of optical elements of the spatial light modulator.

A fifth aspect of the present invention provides a program for letting a computer execute a specific process for controlling a spatial light modulator having a plurality of optical elements arrayed two-dimensionally and being individually controllable,

wherein the computer is made to execute the control method of the fourth aspect.

A sixth aspect of the present invention provides a computer-readable information recording medium in which the program of the fifth aspect is recorded.

A seventh aspect of the present invention provides a spatial light modulating device comprising a spatial light modulator having a plurality of optical elements arrayed two-dimensionally and being individually controllable, and a control unit for controlling the plurality of optical elements, the spatial light modulating device being used in an illumination optical system which forms a predetermined light intensity distribution on an illumination pupil on the basis of light from a light source having traveled via the spatial light modulator and which illuminates an illumination target surface on the basis of light having traveled via the illumination pupil,

wherein the control unit integrally controls postures of a group of optical elements according to a shape of the predetermined light intensity distribution formed on the illumination pupil, out of the plurality of optical elements of the spatial light modulator.

**Effects of the Invention**

The illumination optical system of the present invention is configured to integrally control postures of a group of mirror elements according to the shape of the light intensity distribution formed on the illumination pupil, i.e., the pupil intensity distribution, out of the large number of mirror elements constituting the spatial light modulator of a reflection type, for example. Specifically, for example, a large number of mirror element groups each including a plurality of mirror elements adjacent to each other are virtually set, and respective postures of each group of mirror elements are integrally controlled so that reflected light beams from each group of mirror elements each are directed toward a common region on the illumination pupil plane. As a result of it, it is feasible to reduce a blur width of a diffraction image formed in the common region on the illumination pupil plane by the group of mirror elements integrally posture-controlled and, in turn, to reduce the influence of the diffraction blur on the pupil intensity distribution.

In this manner, the illumination optical system of the present invention is able to achieve a desired pupil intensity distribution, for example, while suppressing the influence of the diffraction blur of the diffraction images formed on the illumination pupil by the reflected light from the microscopic mirror elements arranged regularly. The exposure apparatus of the present invention is able to perform excellent exposure under an appropriate illumination condition achieved according to a pattern characteristic of the mask, using the illumination optical system achieving the desired pupil intensity distribution while suppressing the influence of the diffraction blur, and, in turn, to manufacture excellent devices.

**Brief Description of the Drawings**

Fig. 1 is a drawing schematically showing a configuration of an exposure apparatus according to an embodiment of the present invention.
Fig. 2 is a drawing schematically showing configurations of a spatial light modulating unit and a zoom optical system.
Fig. 3 is a partial perspective view of a spatial light modulator incorporated in the spatial light modulating unit.
Fig. 4 is a drawing showing a typical shape and position relation between a reflecting surface of a mirror element and an aperture.
Fig. 5 is a drawing showing light intensity distributions of diffraction images obtained by calculation based on Eq (1) in a specific numerical example.
Fig. 6 is a drawing schematically showing a first configuration example of a prism member having the same function as a K prism in the embodiment.
Fig. 7 is a drawing schematically showing a second configuration example of a prism member having the same function as the K prism in the embodiment.
Fig. 8 is a drawing schematically showing a configuration example of an assembled optical member having the same function as the K prism in the embodiment.
Fig. 9 is a flowchart showing manufacturing steps of semiconductor devices.
Fig. 10 is a flowchart showing manufacturing steps of a liquid crystal device such as a liquid crystal display device.

**List of Reference Symbols**

| | |
|---|---|
| 1 | light source |
| 2 | beam sending unit |
| 3 | spatial light modulating unit |
| 3a | 3 spatial light modulator |
| 3b | K prism |
| 3c | drive unit |
| 4 | zoom optical system |
| 5 | fly's eye lens |
| 6 | condenser optical system |
| 7 | illumination field stop (mask blind) |
| 8 | field stop imaging optical system |
| 10 | pupil distribution measuring unit |
| IL | illumination optical system |
| CR | control unit |
| M | mask |
| PL | projection optical system |
| W | wafer |

**BEST MODES FOR CARRYING OUT THE INVENTION**

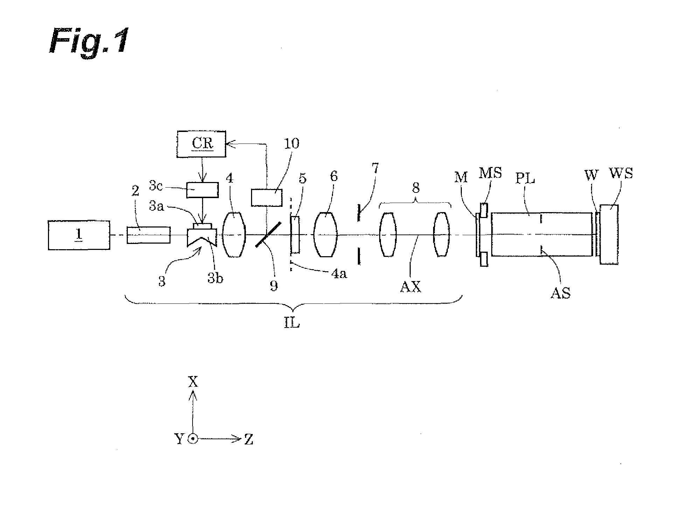

Embodiments of the present invention will be described on the basis of the accompanying drawings. Fig. 1 is a drawing schematically showing a configuration of an exposure apparatus according to an embodiment of the present invention. In Fig. 1, the Z-axis is set along a direction of a normal to a wafer W being a photosensitive substrate, the X-axis is set along a direction parallel to the plane of Fig. 1 in an exposed surface of the wafer W, and the Y-axis is set along a direction perpendicular to the plane of Fig. 1 in the exposed surface of the wafer W.

Referring to Fig. 1, the exposure apparatus of the present embodiment has an illumination optical system IL including a spatial light modulating unit 3, a mask stage MS supporting a mask M, a projection optical system PL, and a wafer stage WS supporting the wafer W, along the optical axis AX of the apparatus. The exposure apparatus of the present embodiment is configured to illuminate the mask M with illumination light (exposure light) from a light source 1 through the illumination optical system IL. Light transmitted by the mask M travels through the projection optical system PL to form an image of a pattern of the mask M on the wafer W.

The illumination optical system IL for illuminating a pattern surface (illumination target surface) of the mask M on the basis of the light from the light source 1 implements modified illumination such as multi-polar illumination (dipolar illumination, quadrupolar illumination, or the like) or annular illumination by action of the spatial light modulating unit 3. The illumination optical system IL has, in order from the light source 1 side along the optical axis AX, a beam sending unit 2, the spatial light modulating unit 3, a zoom optical system 4, a fly's eye lens 5, a condenser optical system 6, an illumination field stop (mask blind) 7, and a field stop imaging optical system 8.

The spatial light modulating unit 3 forms a desired light intensity distribution (pupil intensity distribution) in its far field region (Fraunhofer diffraction region), based on the light from the light source 1 through the beam sending unit 2. The configuration and action of the spatial light modulating unit 3 will be described later. The beam sending unit 2 has functions to guide an incident beam from the light source 1 to the spatial light modulating unit 3 while converting the incident beam into a beam having a cross section of an appropriate size and shape, and to actively correct variation in position and variation in angle of the beam incident to the spatial light modulating unit 3. The zoom optical system 4 condenses the light from the spatial light modulating unit 3 and guides the condensed light to the fly's eye lens 5.

The fly's eye lens 5 is an optical integrator of a wavefront division type consisting of a large number of lens elements arrayed densely, for example. The fly's eye lens 5 divides the wavefront of the incident beam to form a secondary light source (substantial surface illuminant) consisting of light source images as many as the lens elements, on its rear focal plane. An entrance plane of the fly's eye lens 5 is arranged at or near the rear focus position of the zoom optical system 4. The fly's eye lens 5 to be used herein can be, for example, a cylindrical micro fly's eye lens. The configuration and action of the cylindrical micro fly's eye lens are disclosed, for example, in U.S. Pat. No. 6,913,373. It is also possible to use, for example, the micro fly's eye lens disclosed in U.S. Pat. No. 6,741,394, as the fly's eye lens. The teachings of U.S. Pat. Nos. 6,913,373 and 6,741,394 are incorporated herein by reference.

In the present embodiment, the mask M placed on the illumination target surface of the illumination optical system IL is illuminated by Köhler illumination using the secondary light source formed by the fly's eye lens 5, as a light source. For this, the position where the secondary light source is formed is optically conjugate with a position of an aperture stop AS of the projection optical system PL and a plane where the secondary light source is formed can be called an illumination pupil plane of the illumination optical system IL. Typically, the illumination target surface (the plane where the mask M is placed, or the plane where the wafer W is placed if the illumination optical system is considered to include the projection optical system PL) becomes an optical Fourier transform plane with respect to the illumination pupil plane.

The pupil intensity distribution is a light intensity distribution (luminance distribution) on the illumination pupil plane of the illumination optical system IL or on a plane conjugate with the illumination pupil plane. When the number of divisions of the wavefront by the fly's eye lens 5 is relatively large, an overall light intensity distribution formed on the entrance plane of the fly's eye lens 5 demonstrates a high correlation with an overall light intensity distribution (pupil intensity distribution) of the entire secondary light source. For this reason, the light intensity distributions on the entrance plane of the fly's eye lens 5 and on a plane optically conjugate with the entrance plane can also be called pupil intensity distributions.

The condenser optical system 6 condenses the light emitted from the fly's eye lens 5 to illuminate the illumination field stop 7 in a superimposed manner. Light from the illumination field stop 7 travels through the field stop imaging optical system 8 to form an illumination region being an image of an aperture of the illumination field stop 7, in at least a part of the pattern forming region on the mask M. Fig. 1 is depicted without installation of path bending mirrors for bending the optical axis (optical path eventually), but it should be noted that it is optional to arrange an appropriate number of path bending mirrors in the illumination optical path as needed.

The mask M is mounted along the XY plane (e.g., a horizontal plane) on the mask stage MS and the wafer W is mounted along the XY plane on the wafer stage WS. The projection optical system PL forms an image of the pattern of the mask M on the exposed surface (projection surface) of the wafer W, based on light from the illumination region formed on the pattern surface of the mask M by the illumination optical system IL. In this manner, the pattern of the mask M is successively transferred onto each of exposure regions on the wafer W by carrying out full-shot exposure or scan exposure while two-dimensionally driving and controlling the wafer stage WS in the plane (XY plane) perpendicular to the optical axis AX of the projection optical system PL and, therefore, while two-dimensionally driving and controlling the wafer W.

The exposure apparatus of the present embodiment is provided with a beam splitter 9 arranged in the illumination optical path between the zoom optical system 4 and the fly's eye lens 5, and a pupil distribution measuring unit 10 which detects light reflected by the beam splitter 9 and guided to the outside of the illumination optical path. The pupil distribution measuring unit 10 has a CCD imaging unit having an imaging area, for example, arranged at a position optically conjugate with the entrance plane of the fly's eye lens 5, and monitors the light intensity distribution formed on the entrance plane of the fly's eye lens 5. Namely, the pupil distribution measuring unit 10 has a function to measure the pupil intensity distribution on the illumination pupil or on a plane optically conjugate with the illumination pupil. The result of the measurement by the pupil distribution measuring unit 10 is supplied to the control unit CR. The detailed configuration and action of the pupil distribution measuring unit 10 can be found, for example, with reference to Japanese Patent Application Laid-open No. 2006-054328. It is also possible to adopt the technology disclosed in Japanese Patent Application Laid-open No. 2003-22967 and U.S. Pat. Published Application No. 2003/0038225 corresponding thereto. The teachings of U.S. Pat. Published Application No. 2003/0038225 are incorporated herein by reference.

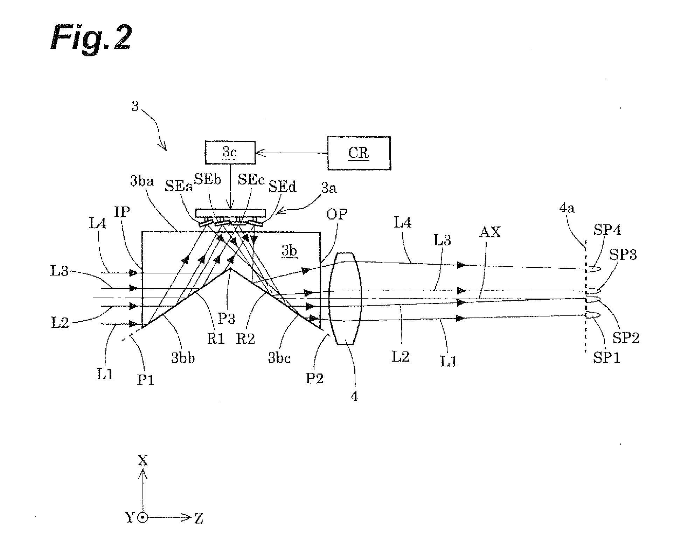

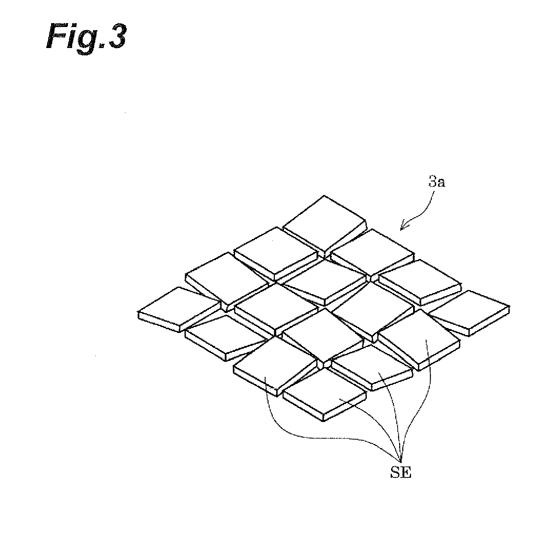

The configuration and action of the spatial light modulating unit 3 will be described below with reference to Figs. 2 and 3. Fig. 2 is a drawing schematically showing configurations of the spatial light modulating unit 3 and the zoom optical system 4. Fig. 3 is a partial perspective view of spatial light modulator 3a incorporated in the spatial light modulating unit 3. The spatial light modulating unit 3, as shown in Fig. 2, has a prism 3b made of an optical material, e.g., like fluorite, and a spatial light modulator 3a of a reflection type installed in proximity to a side face 3ba of the prism 3b parallel to the YZ plane. The optical material making up the prism 3b does not have to be limited to fluorite, but may be quartz or any other optical material depending, for example, upon the wavelength of the light supplied from the light source 1.

The prism 3b has a form obtained by replacing one side face (side face opposed to the side face 3ba to which the spatial light modulator 3a is installed in proximity) of a rectangular parallelepiped with side faces 3bb and 3bc of a V-shaped indentation, and is also called a K prism because of its cross-sectional shape along the XZ plane. The side faces 3bb and 3bc of the V-shaped indentation in the prism 3b are defined by two planes P1 and P2 intersecting at an obtuse angle. The two planes P1 and P2 both are perpendicular to the XZ plane and form a V-shape along the XZ plane.

Internal surfaces of the two side faces 3bb and 3bc in contact with each other on an intersecting line (straight line extending in the Y-direction) P3 between the two planes P1 and P2 function as reflecting surfaces R1 and R2. Namely, the reflecting surface R1 is located on the plane P1, the reflecting surface R2 is located on the plane P2, and the angle between the reflecting surfaces R1 and R2 is an obtuse angle. As an example, the angle between the reflecting surfaces R1 and R2 can be 120°, the angle between an input plane IP of the prism 3b normal to the optical axis AX, and the reflecting surface R1 60°, and the angle between an output plane OP of the prism 3b normal to the optical axis AX, and the reflecting surface R2 60°.

The prism 3b is arranged so that the side face 3ba, to which the spatial light modulator 3a is installed in proximity, is parallel to the optical axis AX and so that the reflecting surface R1 is located on the light source 1 side (upstream in the exposure apparatus: on the left in Fig. 2) and the reflecting surface R2 on the fly's eye lens 5 side (downstream in the exposure apparatus: on the right in Fig. 2). More specifically, the reflecting surface R1 is inclined with respect to the optical axis AX and the reflecting surface R2 is inclined with respect to the optical axis AX in symmetry with the reflecting surface R1 with respect to a plane passing the tangent line P3 and being parallel to the XY plane. The side face 3ba of the prism 3b is an optical surface opposed to the plane where a plurality of mirror elements SE of the spatial light modulator 3a are arrayed, as described below.

The reflecting surface R1 of the prism 3b reflects light incident thereto through the input plane IP, toward the spatial light modulator 3a. The spatial light modulator 3a is arranged in the optical path between the reflecting surface R1 and the reflecting surface R2 and reflects the light incident thereto via the reflecting surface R1. The reflecting surface R2 of the prism 3b reflects the light incident thereto via the spatial light modulator 3a and guides the light through the output plane OP to the zoom optical system 4. Fig. 2 shows an example in which the prism 3b is integrally formed of a single optical block, but the prism 3b may also be constructed of a plurality of optical blocks as described below. Fig. 2 is depicted without illustration of the beam splitter 9.

The spatial light modulator 3a imparts spatial modulations according to positions of incidence of incident rays, to the rays incident thereto via the reflecting surface R1 and outputs the spatially modulated rays. The spatial light modulator 3a, as shown in Fig. 3, has a plurality of microscopic mirror elements (optical elements) SE arrayed two-dimensionally. For simplicity of description and illustration, Figs. 2 and 3 show a configuration example wherein the spatial light modulator 3a has 4x4=16 mirror elements SE, but in fact the spatial light modulator 3 a has many more mirror elements SE than 16 elements.

With reference to Fig. 2, among a group of rays incident along a direction parallel to the optical axis AX into the spatial light modulating unit 3, a ray L1 is incident to a mirror element SEa out of the plurality of mirror elements SE, and a ray L2 is incident to a mirror element SEb different from the mirror element SEa. Similarly, a ray L3 is incident to a mirror element SEc different from the mirror elements SEa, SEb, and a ray L4 is incident to a mirror element SEd different from the mirror elements SEa-SEc. The mirror elements SEa-SEd impart respective spatial modulations set according to their positions, to the rays L1-L4.

The spatial light modulating unit 3 is configured in a configuration wherein in a standard state in which reflecting surfaces of all the mirror elements SE of the spatial light modulator 3a are set in parallel with the YZ plane, rays incident along the direction parallel to the optical axis AX to the reflecting surface R1 travel via the spatial light modulator 3a and thereafter are reflected to the direction parallel to the optical axis AX by the reflecting surface R2. The spatial light modulating unit 3 is also configured so that an air equivalent length from the input plane IP of the prism 3b to the output plane OP via the mirror elements SEa-SEd is equal to an air equivalent length from a position corresponding to the input plane IP to a position corresponding to the output plane OP without the prism 3b in the optical path. The air equivalent length herein is an optical path length in air with the refractive index of 1 reduced from the optical path length in the optical system, and an air equivalent length in a medium with the refractive index of n is a value obtained by multiplying the optical path length by 1/n.

The spatial light modulator 3a is arranged at or near the front focus position of the zoom optical system 4. The rays reflected and given a predetermined angle distribution by the plurality of mirror elements SEa-SEd of the spatial light modulator 3a form predetermined light intensity distributions SP1-SP4 on the rear focal plane 4a of the zoom optical system 4. Namely, the zoom optical system 4 converts angles given to the output rays by the plurality of mirror elements SEa-SEd of the spatial light modulator 3a, into positions on the plane 4a being the far field region (Fraunhofer diffraction region) of the spatial light modulator 3a.

Referring again to Fig. 1, the entrance plane of the fly's eye lens 5 is positioned at or near the rear focal plane 4a of the zoom optical system 4 functioning as a condensing optical system. Therefore, the light intensity distribution (luminance distribution) of the secondary light source formed by the fly's eye lens 5 becomes a distribution according to the light intensity distributions SP1-SP4 formed by the spatial light modulator 3a and the zoom optical system 4. The spatial light modulator 3a, as shown in Fig. 3, is a movable multi-mirror including the mirror elements SE which are a large number of microscopic reflecting elements arrayed regularly and two-dimensionally along one plane in a state in which their reflecting surfaces of a planar shape are respective top faces.

Each mirror element SE is movable and an inclination of its reflecting surface, i.e., an inclination angle and inclination direction of the reflecting surface, is independently controlled by action of a drive unit 3c (which is not shown in Fig. 3) which operates in accordance with a command from a control unit CR (not shown in Fig. 3). Each mirror element SE is continuously or discretely rotatable by a desired rotation angle around axes of rotation along two mutually orthogonal directions (Y-direction and Z-direction) which are two directions parallel to the reflecting surface. Namely, the inclination of the reflecting surface of each mirror element SE can be two-dimensionally controlled.

When the reflecting surface of each mirror element SE is discretely rotated, a preferred control method is to switch the rotation angle among a plurality of states (e.g., ..., -2.5°, -2.0°,...0°, +0.5°...+2.5°,...). Fig. 3 shows the mirror elements SE with the contour of a square shape, but the contour of the mirror elements SE is not limited to the square shape. However, in terms of light utilization efficiency, it is also possible to adopt a shape enabling an array with a small clearance between the mirror elements SE (shape enabling closest packing). Furthermore, in terms of light utilization efficiency, it is also possible to adopt a configuration wherein the clearance between two adjacent element mirrors SE is reduced to the minimum necessary.

The present embodiment uses as the spatial light modulator 3a, a spatial light modulator which continuously (or discretely) varies each of orientations of the mirror elements SE arrayed two-dimensionally. The spatial light modulator of this type applicable herein can be selected, for example, from the spatial light modulators disclosed in Published Japanese Translation of PCT Application No. 10-503300 and European Patent Published Application No. 779530 corresponding thereto, Japanese Patent Application Laid-open No. 2004-78136 and U.S. Pat. No. 6,900,915 corresponding thereto, Published Japanese Translation of PCT Application No. 2006-524349 and U.S. Pat. No. 7,095,546 corresponding thereto, and Japanese Patent Application Laid-open No. 2006-113437. The teachings of European Patent Published Application No. 779530, U.S. Pat. No. 6,900,915, and U.S. Pat. No. 7,095,546 are incorporated herein by reference.

In the spatial light modulator 3a, postures of the respective mirror elements SE each are varied and the mirror elements SE are set in respective predetermined orientations, by action of the drive unit 3c operating in accordance with a control signal from the control unit CR. Rays reflected at respective predetermined angles by the plurality of mirror elements SE of the spatial light modulator 3a travel through the zoom optical system 4 to form a light intensity distribution (pupil intensity distribution) of a multi-polar shape (dipolar shape, quadrupolar shape, or the like), annular shape, or the like on the illumination pupil at or near the rear focus position of the fly's eye lens 5. This pupil intensity distribution similarly (isotropically) varies by action of the zoom optical system 4.

Namely, the zoom optical system 4 and the fly's eye lens 5 constitute a distribution forming optical system which forms a predetermined light intensity distribution on the illumination pupil of the illumination optical system IL, based on a flux of light having traveled via the spatial light modulator 3a in the spatial light modulating unit 3. Furthermore, light intensity distributions corresponding to the pupil intensity distribution are also formed at other illumination pupil positions optically conjugate with the illumination pupil at or near the rear focus position of the fly's eye lens 5, i.e., at a pupil position of the field stop imaging optical system 8 and at a pupil position of the projection optical system PL (position of the aperture stop AS).

For the exposure apparatus to highly accurately and faithfully transfer the pattern of the mask M onto the wafer W, it is important, for example, to perform exposure under an appropriate illumination condition according to a pattern characteristic of the mask M. Since the present embodiment adopts the spatial light modulating unit 3 with the spatial light modulator 3a wherein the postures of the mirror elements SE each are individually varied, the pupil intensity distribution formed by action of the spatial light modulator 3a can be freely and quickly varied.

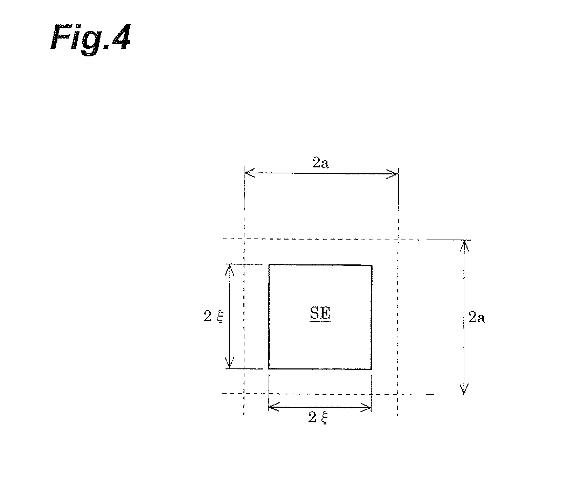

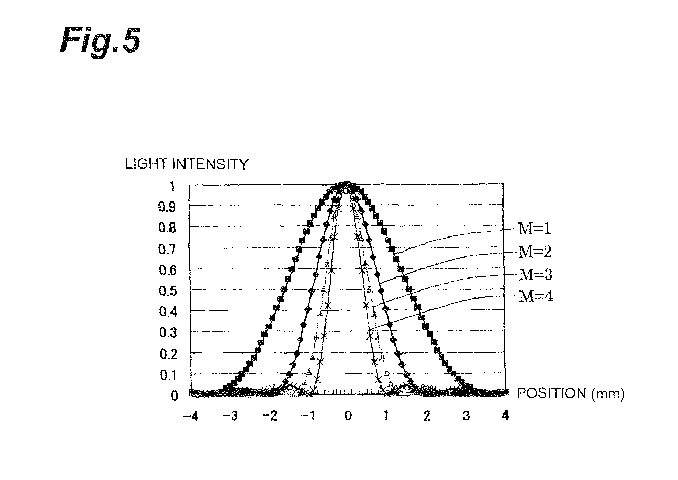

However, the illumination optical system IL of the present embodiment using the spatial light modulator 3a causes a phenomenon in which a tail of a light intensity distribution of a diffraction image formed on the illumination pupil by reflected light from one of the microscopic mirror elements SE arranged regularly spreads out of a region corresponding to the mirror element SE to extend relatively largely, i.e., a diffraction blur. As a result of it, it is sometimes difficult to form a desired pupil intensity distribution because of influence of the diffraction blur. The diffraction blur and influence thereof will be described below with reference to Figs. 4 and 5.

The spatial light modulator 3a is, for example, an aggregate of microscopic mirror elements (reflecting mirrors) SE having a rectangular contour and arrayed regularly. For taking diffraction at the spatial light modulator 3a into consideration, therefore, an available model is a multi-slit model in which a plurality of identical apertures are arrayed in parallel. For simplicity of description, it is assumed that each mirror element SE of the spatial light modulator 3a has a reflecting surface of a square shape having a length of $2\xi$ on each side and is positioned in a center of a square aperture having a length of 2a on each side, as shown in Fig. 4.

In this case, a diffraction image formed on the entrance plane of the fly's eye lens 5 through the zoom optical system 4 by reflected light from the mirror element SE, or, in turn, a light intensity distribution I(x) of a diffraction image formed on the illumination pupil at the rear focal plane of the fly's eye lens 5 is represented by Eq (1) below (cf. "Kougaku Gairon II" p82 authored by Tsujiuchi). In Eq (1), $I_0$ is a light intensity at the center of the diffraction image formed on the illumination pupil by reflected light from one mirror element SE, f the focal length of the zoom optical system 4 as a relay optical system, $\lambda$ the wavelength of light, x a coordinate of position on the illumination pupil plane, and M the number of mirror elements SE in a group integrally posture-controlled toward one common region on the illumination pupil plane.
[Math 1]

$$I(x) = I_0 \left( \frac{\sin \dfrac{2\pi \xi x}{\lambda f}}{\dfrac{2\pi \xi x}{\lambda f}} \right) \left( \frac{\sin \dfrac{2\pi M a x}{\lambda f}}{M \sin \dfrac{2\pi a x}{\lambda f}} \right) \qquad (1)$$

In passing, an aperture ratio (fill factor) defined by $\xi/a$ is approximately 85% to 90% in the spatial light modulator 3a. Specifically, Fig. 5 shows the light intensity distributions of the diffraction images obtained by calculation based on Eq (1) on the assumption that the length $2\xi$ of each side of the reflecting surface of each mirror element SE is 16 $\mu$m, the aperture ratio $\xi/a$ is 85%, the focal length f of the zoom optical system 4 is 300 mm, the wavelength $\lambda$ of light is 193 nm, and the number M of mirror elements SE in a group is from 1 to 4. In Fig. 5, the vertical axis represents the light intensity with the maximum light intensity at the center of the diffraction image being normalized to 1, and the horizontal axis the position coordinate x (mm) on the illumination pupil plane.

With reference to Fig. 5, it is seen that with M = 1 the spread of the tail of the light intensity distribution of the diffraction image formed on the illumination pupil by the reflected light from the single mirror element SE is the largest, about 7 mm, and that the spread of the tail of the light intensity distribution of the diffraction image decreases with increase in the number M of mirror elements SE in a group integrally posture-controlled toward one common region on the illumination pupil plane. In other words, a width of the diffraction blur or a blur width can be decreased by increasing the number M of mirror elements SE in the group integrally posture-controlled. In fact, since the aperture ratio $\xi/a$ is about 90%, the blur width is simply $2\lambda f/(2M\xi)$ and is inversely proportional to the number M of mirror elements SE in the group.

In the illumination optical system IL of the present embodiment, based on the foregoing expertise, postures of a group of mirror elements SE according to the shape of the pupil intensity distribution, out of the large number of mirror elements SE forming the spatial light modulator 3a, are integrally controlled by action of the drive unit 3c operating in accordance with a control signal from the control unit CR. Specifically, for example, a large number of mirror element groups each including a plurality of (e.g., two to four) mirror elements SE adjacent to each other are virtually set and respective postures of each group of mirror elements SE are integrally controlled so that reflected beams from each group of mirror elements SE each travel toward a common region on the illumination pupil plane.

As a result of this, it is feasible to reduce the blur width of the diffraction image formed in the common region on the illumination pupil plane by the group of mirror elements SE integrally posture-controlled and, in turn, to reduce influence of the diffraction blur on the pupil intensity distribution. In this manner, the illumination optical system IL of the present embodiment is able to achieve a desired pupil intensity distribution while suppressing the influence of the diffraction blur of the diffraction images formed on the illumination pupil by the reflected light from the microscopic mirror elements SE arranged regularly. The exposure apparatus (3-WS) of the present embodiment is able to perform excellent exposure under an appropriate illumination condition achieved according to a pattern characteristic of the mask M, using the illumination optical system IL achieving the desired pupil intensity distribution while suppressing the influence of the diffraction blur. In the foregoing embodiment, when a flux of beams from a group of mirror elements SE integrally posture-controlled reaches one common region on the illumination pupil plane, a divergence angle of the beam flux becomes large (i.e., the numerical aperture of the beam flux becomes large), and therefore it can also be considered that the blur width of the diffraction image formed on this common region becomes small.

However, if all the mirror elements SE of the spatial light modulator 3a are virtually divided into a large number of mirror element groups and respective postures of mirror elements SE in each group are integrally controlled, it is sometimes the case that degrees of freedom become lowered about change in shape and size of the pupil intensity distribution. The most significant influence of the diffraction blur occurs in an edge region of the contour of the pupil intensity distribution. For example, in peripheral edge regions of respective poles in a multi-polar pupil intensity distribution or in an outer peripheral edge region and an inner peripheral edge region in an annular pupil intensity distribution, the pupil intensity distribution spreads out of a predetermined region because of the influence of the diffraction blur.

Therefore, in order to achieve both of securing high degrees of freedom about change in shape and size of the pupil intensity distribution and reducing the influence of the diffraction blur on the pupil intensity distribution, it is preferable to virtually divide only mirror elements SE for formation of the edge region of the pupil intensity distribution into a large number of mirror element groups. In this case, the pupil intensity distribution in the edge region is formed by integrally controlling the respective postures of the mirror elements SE in each group, while the pupil intensity distribution in the region (particularly, the central region) except for the edge region is formed by individually controlling the postures of the other mirror elements SE except for the plurality of mirror element groups.

As described above, when the aperture ratio $\xi/a$ is about 90%, the blur width is represented by $2\lambda f/(2M\xi)$ according to the number M of mirror elements SE in a group integrally posture-controlled. The exposure apparatus of the present embodiment is able to check whether the required reduction effect about the diffraction blur is achieved, as needed, with reference to the measurement result of the pupil distribution measuring unit 10 for measuring the pupil intensity distribution. The control unit CR controls the spatial light modulator 3a, based on the measurement result of the pupil distribution measuring unit 10, whereby it can perform such feedback adjustment as to make the actually formed pupil intensity distribution closer to the desired pupil intensity distribution. Another available method is to determine angle components of light obtained by Fourier transform of the shape of the pupil intensity distribution by preliminary calculation and to integrally control respective postures of mirror elements SE in each group forming the edge region of the pupil intensity distribution, in accordance with a predetermined algorithm.

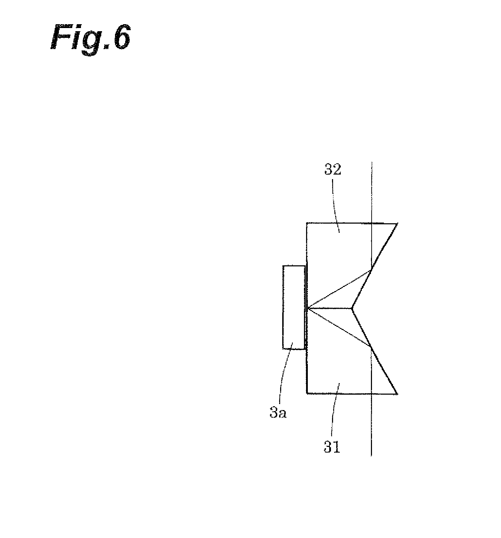

In the above description, the K prism 3b integrally formed of a single optical block is used as the prism member having the optical surface opposed to the plane where the plurality of mirror elements of the spatial light modulator 3a are arrayed. However, without having to be limited to this, it is also possible to adopt a configuration wherein a prism member having the same function as the K prism 3b is composed of a pair of prisms 31 and 32, for example, as shown in Fig. 6. In this case, light passes through contact surfaces of the prisms 31 and 32 and it is thus necessary to polish the contact surfaces. In some cases, it is necessary to achieve optical contact between the prisms 31 and 32.

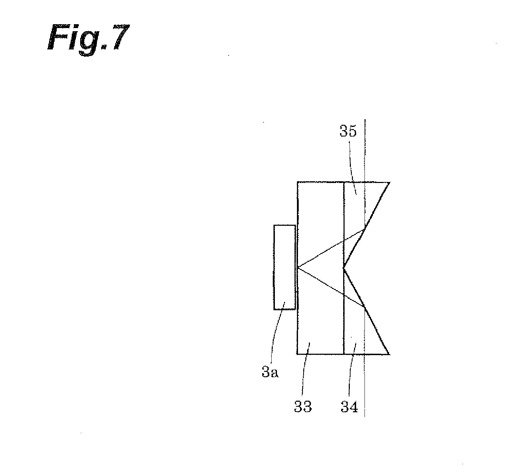

Furthermore, a prism member having the same function as the K prism 3b can also be constructed, for example, by a plane-parallel plate 33 and a pair of triangular prisms 34 and 35 as shown in Fig. 7. Since the triangular prisms 34 and 35 are not in contact with each other, there is no need for optical contact between the triangular prisms 34 and 35. The plane-parallel plate 33 and the triangular prisms 34, 35 may be arranged in contact with each other or may be arranged with a space between them. Since the plane-parallel plate 33 also serves as a cover glass for the spatial light modulator 3a, the triangular prisms 34 and 35 do not have to be replaced while the plane-parallel plate 33 and the spatial light modulator 3a are replaced, in replacement after a lapse of a lifetime of the spatial light modulator 3 a.

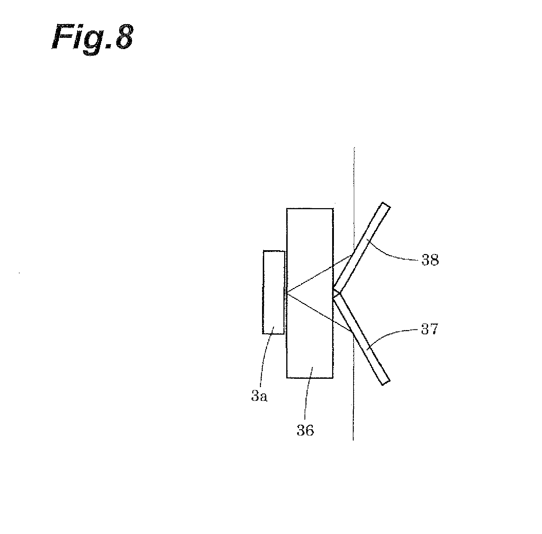

It is also possible to construct an assembled optical member having the same function as the K prism 3b, for example, by a plane-parallel plate 36 and a pair of plane mirrors 37 and 38, for example, as shown in Fig. 8. The configuration shown in Fig. 8 is obtained by replacing the triangular prisms 34 and 35 in Fig. 7 with the plane mirrors 37 and 38. In this case, just as in the case of the configuration example of Fig. 7, there is no need for replacement of the plane mirrors 37 and 38 with need for replacement of the plane-parallel plate 36 and the spatial light modulator 3a in replacement after the lapse of the lifetime of the spatial light modulator 3a. Furthermore, the angle of the light incident to the spatial light modulator 3a can be made smaller by the degree of refraction of the light incident from the plane mirror 37 into the plane-parallel plate 36 than that in the configuration example of Fig. 7.

In the above description, the spatial light modulator in which the orientations (angles: inclinations) of the reflecting surfaces arrayed two-dimensionally can be individually controlled is used as the spatial light modulator having the plurality of optical elements arrayed two-dimensionally and controlled individually. However, without having to be limited to this, it is also possible, for example, to apply a spatial light modulator in which heights (positions) of the reflecting surfaces arrayed two-dimensionally can be individually controlled. Such a spatial light modulator applicable herein can be selected, for example, from those disclosed in Japanese Patent Application Laid-open No. 6-281869 and U.S. Pat. No. 5,312,513 corresponding thereto, and in Fig. 1d of Published Japanese Translation of PCT Application No. 2004-520618 and U.S. Pat. No. 6,885,493 corresponding thereto. These spatial light modulators are able to apply the same action as a diffracting surface, to incident light by forming a two-dimensional height distribution. The aforementioned spatial light modulator having the plurality of reflecting surfaces arrayed two-dimensionally may be modified, for example, according to the disclosure in Published Japanese Translation of PCT Application No. 2006-513442 and U.S. Pat. No. 6,891,655 corresponding thereto, or according to the disclosure in Published Japanese Translation of PCT Application No. 2005-524112 and U.S. Pat. Published Application No. 2005/0095749 corresponding thereto.

In the above description, the spatial light modulator applied is the reflection type spatial light modulator having the plurality of mirror elements, but, without having to be limited to this, it is also possible, for example, to apply the transmission type spatial light modulator disclosed in U.S. Pat. No. 5,229,872. The teachings of U.S. Pat. Nos. 5,312,513, 6,885,493, and 6,891,655, U.S. Pat. Published Application No. 2005/0095749, and U.S. Pat. No. 5,229,872 are incorporated herein by reference.

In the aforementioned embodiment, the mask can be replaced with a variable pattern forming device which forms a predetermined pattern on the basis of predetermined electronic data. Use of such a variable pattern forming device can minimize influence on synchronization accuracy even if the pattern surface is set vertical. The variable pattern forming device applicable herein can be, for example, a DMD (Digital Micromirror Device) including a plurality of reflective elements driven based on predetermined electronic data. The exposure apparatus with the DMD is disclosed, for example, in Japanese Patent Application Laid-open No. 2004-304135, International Publication WO2006/080285, and U.S. Pat. Published Application No. 2007/0296936 corresponding thereto. Besides the reflective spatial light modulators of the non-emission type like the DMD, it is also possible to apply a transmission type spatial light modulator or a self-emission type image display device. It is noted that the variable pattern forming device can also be used in cases where the pattern surface is set horizontal. The teachings of U.S. Pat. Published Application No. 2007/0296936 are incorporated herein by reference.

In the foregoing embodiment, the fly's eye lens 5 was used as an optical integrator, but an optical integrator of an internal reflection type (typically, a rod type integrator) may be used instead thereof. In this case, a condenser lens is arranged behind the zoom optical system 4 so that its front focus position coincides with the rear focus position of the zoom optical system 4, and the rod type integrator is arranged so that an entrance end thereof is positioned at or near the rear focus position of the condenser lens. At this time, an exit end of the rod type integrator is at the position of the illumination field stop 7. In the use of the rod type integrator, a position optically conjugate with the position of the aperture stop AS of the projection optical system PL, in the field stop imaging optical system 8 downstream the rod type integrator can be called an illumination pupil plane. Since a virtual image of the secondary light source on the illumination pupil plane is formed at the position of the entrance plane of the rod type integrator, this position and positions optically conjugate therewith can also be called illumination pupil planes. The zoom optical system 4 and the foregoing condenser lens can be regarded as a condensing optical system arranged in the optical path between the optical integrator and the spatial light modulator, and the zoom optical system 4, the foregoing condenser lens, and the rod type integrator can be regarded as a distribution forming optical system.

In the exposure apparatus of the above embodiment, a program for letting the control unit CR execute the procedure of controlling the postures of the large number of mirror elements SE constituting the spatial light modulator 3a in the spatial light modulating unit 3, is installed in a memory part connected to the control unit CR, through a CD-ROM drive from an information storage medium such as CD-ROM, or in a memory area in the control unit CR.

The exposure apparatus of the foregoing embodiment is manufactured by assembling various sub-systems containing their respective components as set forth in the scope of claims in the present application, so as to maintain predetermined mechanical accuracy, electrical accuracy, and optical accuracy. For ensuring these various accuracies, the following adjustments are carried out before and after the assembling: adjustment for achieving the optical accuracy for various optical systems; adjustment for achieving the mechanical accuracy for various mechanical systems; adjustment for achieving the electrical accuracy for various electrical systems. The assembling steps from the various sub-systems into the exposure apparatus include mechanical connections, wire connections of electric circuits, pipe connections of pneumatic circuits, etc. between the various sub-systems. It is needless to mention that there are assembling steps of the individual sub-systems, before the assembling steps from the various sub-systems into the exposure apparatus. After completion of the assembling steps from the various sub-systems into the exposure apparatus, overall adjustment is carried out to ensure various accuracies as the entire exposure apparatus. The manufacture of the exposure apparatus may be performed in a clean room in which the temperature, cleanliness, etc. are controlled.

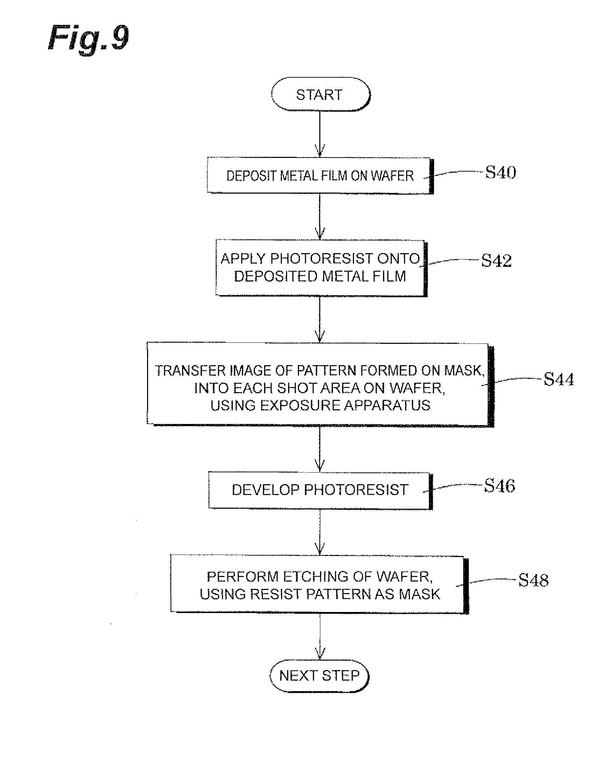

The following will describe a device manufacturing method using the exposure apparatus according to the above-described embodiment. Fig. 9 is a flowchart showing manufacturing steps of semiconductor devices. As shown in Fig. 9, the manufacturing steps of semiconductor devices include depositing a metal film on a wafer W to become a substrate of semiconductor devices (step S40) and applying a photoresist as a photosensitive material onto the deposited metal film (step S42). The subsequent steps include transferring a pattern formed on a mask (reticle) M, into each shot area on the wafer W, using the projection exposure apparatus of the above embodiment (step S44: exposure step), and developing the wafer W after completion of the transfer, i.e., developing the photoresist on which the pattern is transferred (step S46: development step). Thereafter, using the resist pattern made on the surface of the wafer W in step S46, as a mask, processing such as etching is carried out on the surface of the wafer W (step S48: processing step).

The resist pattern herein is a photoresist layer in which depressions and projections are formed in a shape corresponding to the pattern transferred by the projection exposure apparatus of the above embodiment and which the depressions penetrate throughout. Step S48 is to process the surface of the wafer W through this resist pattern. The processing carried out in step S48 includes, for example, at least either etching of the surface of the wafer W or deposition of a metal film or the like. In step S44, the projection exposure apparatus of the above embodiment performs the transfer of the pattern onto the wafer W coated with the photoresist, as a photosensitive substrate or plate P.

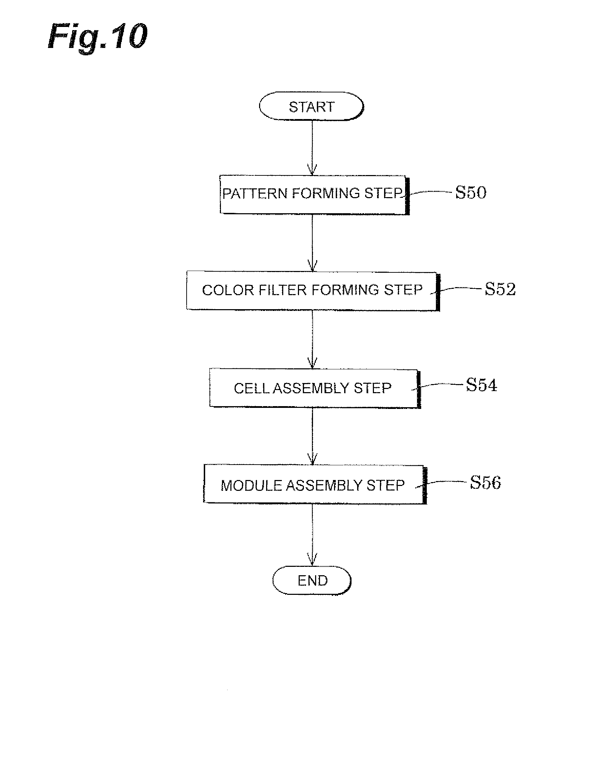

Fig. 10 is a flowchart showing manufacturing steps of a liquid crystal device such as a liquid crystal display device. As shown in Fig. 10, the manufacturing steps of the liquid crystal device include sequentially performing a pattern forming step (step S50), a color filter forming step (step S52), a cell assembly step (step S54), and a module assembly step (step S56).

The pattern forming step of step S50 is to form predetermined patterns such as a circuit pattern and an electrode pattern on a glass substrate coated with a photoresist, as a plate P, using the aforementioned projection exposure apparatus of the above embodiment. This pattern forming step includes an exposure step of transferring a pattern to a photoresist layer, using the projection exposure apparatus of the above embodiment, a development step of performing development of the plate P on which the pattern is transferred, i.e., development of the photoresist layer on the glass substrate, to form the photoresist layer in the shape corresponding to the pattern, and a processing step of processing the surface of the glass substrate through the developed photoresist layer.

The color filter forming step of step S52 is to form a color filter in which a large number of sets of three dots corresponding to R (Red), G (Green), and B (Blue) are arrayed in a matrix pattern, or in which a plurality of filter sets of three stripes of R, G, and B are arrayed in a horizontal scan direction.

The cell assembly step of step S54 is to assemble a liquid crystal panel (liquid crystal cell), using the glass substrate on which the predetermined pattern has been formed in step S50, and the color filter formed in step S52. Specifically, for example, a liquid crystal is poured into between the glass substrate and the color filter to form the liquid crystal panel. The module assembly step of step S56 is to attach various components such as electric circuits and backlights for display operation of this liquid crystal panel, to the liquid crystal panel assembled in step S54.

The present invention is not limited just to the application to the exposure apparatus for manufacture of semiconductor devices, but can also be widely applied, for example, to the exposure apparatus for the liquid crystal display devices formed with rectangular glass plates, or for display devices such as plasma displays, and to the exposure apparatus for manufacture of various devices such as imaging devices (CCDs and others), micro machines, thin film magnetic heads, and DNA chips. Furthermore, the present invention is also applicable to the exposure step (exposure apparatus) for manufacture of masks (photomasks, reticles, etc.) on which mask patterns of various devices are formed, by the photolithography process.

The above-described embodiment can use the ArF excimer laser light (wavelength: 193 nm) or the KrF excimer laser light (wavelength: 248 nm) as the exposure light. Furthermore, without having to be limited to this, the present invention can also use any other appropriate laser light source, e.g., an $F_2$ laser light source which supplies laser light at the wavelength of 157 nm.

In the foregoing embodiment, it is also possible to apply a technique of filling the interior of the optical path between the projection optical system and the photosensitive substrate with a medium having the refractive index larger than 1.1 (typically, a liquid), which is so called a liquid immersion method. In this case, it is possible to adopt one of the following techniques as a technique of filling the interior of the optical path between the projection optical system and the photosensitive substrate with the liquid: the technique of locally filling the optical path with the liquid as disclosed in International Publication WO99/49504; the technique of moving a stage holding the substrate to be exposed, in a liquid bath as disclosed in Japanese Patent Application Laid-open No. 6-124873; the technique of forming a liquid bath of a predetermined depth on a stage and holding the substrate therein as disclosed in Japanese Patent Application Laid-open No. 10-303114, and so on. The teachings of International Publication WO99/49504, Japanese Patent Application Laid-open No. 6-124873, and Japanese Patent Application Laid-open No. 10-303114 are incorporated herein by reference.

In the above embodiment, it is also possible to apply the so-called polarization illumination methods as disclosed in U.S. Pat. Published Application Nos. 2006/0170901 and 2007/0146676. The teachings of U.S. Pat. Published Application Nos. 2006/0170901 and 2007/0146676 are incorporated herein by reference.

The foregoing embodiment was the application of the present invention to the illumination optical system for illuminating the mask in the exposure apparatus, but, without having to be limited to this, the present invention can also be applied to commonly-used illumination optical systems for illuminating an illumination target surface except for the mask.

**Claims**

1. An illumination optical system which illuminates an illumination target surface on the basis of light from a light source, said illumination optical system comprising:

   a spatial light modulator having a plurality of optical elements arrayed two-dimensionally and being individually controllable;
   a distribution forming optical system which forms a predetermined light intensity distribution on an illumination pupil of the illumination optical system on the basis of light having traveled via the spatial light modulator; and
   a control unit which integrally controls postures of a group of optical elements according to a shape of the predetermined light intensity distribution formed on the illumination pupil, out of the plurality of optical elements.

2. The illumination optical system according to claim 1, wherein the group of optical elements have a plurality of optical elements adjacent to each other.

3. The illumination optical system according to claim 2, wherein light having traveled via the plurality of optical elements adjacent to each other is directed toward an edge region of a contour of the predetermined light intensity distribution formed on the illumination pupil.

4. The illumination optical system according to any one of claims 1 to 3, wherein the spatial light modulator has a plurality of mirror elements arrayed two-dimensionally, and a drive unit for individually controlling and driving postures of the plurality of mirror elements.

5. The illumination optical system according to claim 4, wherein the drive unit continuously varies orientations of the plurality of mirror elements.

6. The illumination optical system according to any one of claims 1 to 5, wherein the distribution forming optical system has an optical integrator, and a condensing optical system arranged in an optical path between the optical integrator and the spatial light modulator.

7. The illumination optical system according to any one of claims 1 to 6, which is used in combination with a projection optical system for forming a plane optically conjugate with the illumination target surface, wherein the illumination pupil is a position optically conjugate with an aperture stop of the projection optical system.

8. An exposure apparatus comprising the illumination optical system as set forth in any one of claims 1 to 7 for illuminating a predetermined pattern, wherein the predetermined pattern is transferred onto a photosensitive substrate to effect exposure thereof.

9. The exposure apparatus according to claim 8, further comprising a pupil distribution measuring unit which measures the predetermined light intensity distribution formed on the illumination pupil, on the illumination pupil or on a plane optically conjugate with the illumination pupil, wherein the control unit controls the spatial light modulator, based on a result of measurement by the pupil distribution measuring unit.

10. A device manufacturing method comprising:

    an exposure step of transferring the predetermined pattern onto the photosensitive substrate to effect exposure thereof, using the exposure apparatus as set forth in claim 8 or 9;
    a development step of developing the photosensitive substrate on which the predetermined pattern is transferred, to form a mask layer of a shape corresponding to the predetermined pattern on a surface of the photosensitive substrate; and
    a processing step of processing the surface of the photosensitive substrate through the mask layer.

11. An illumination method for illuminating an illumination target surface on the basis of light from a light source through an illumination optical system, said illumination method comprising:

a first step of guiding light to a spatial light modulator having a plurality of optical elements arrayed two-dimensionally and being individually controllable; and

a second step of forming a predetermined light intensity distribution on an illumination pupil of the illumination optical system on the basis of light having traveled via the spatial light modulator,

wherein the first step comprises integrally controlling postures of a group of optical elements according to a shape of the predetermined light intensity distribution formed on the illumination pupil, out of the plurality of optical elements.

12. The illumination method according to claim 11, wherein the first step comprises integrally controlling postures of a plurality of optical elements adjacent to each other.

13. The illumination method according to claim 12, wherein light having traveled via the plurality of optical elements adjacent to each other is directed toward an edge region of a contour of the predetermined light intensity distribution formed on the illumination pupil.

14. The illumination method according to any one of claims 11 to 13, wherein the second step comprises a third step of guiding the light having traveled via the spatial light modulator, to a condensing optical system, and a fourth step of guiding the light from the spatial light modulator having traveled via the condensing optical system, to an optical integrator.

15. The illumination method according to any one of claims 11 to 14, which is used in combination with a projection optical system for forming a plane optically conjugate with the illumination target surface on the basis of light from the illumination target surface, wherein the illumination pupil is a position optically conjugate with an aperture stop of the projection optical system.

16. An exposure method comprising illuminating a predetermined pattern by the illumination method as set forth in any one of claims 11 to 15, to transfer the predetermined pattern onto a photosensitive substrate to effect exposure thereof.

17. The exposure method according to claim 16, further comprising a pupil distribution measuring step of measuring the predetermined light intensity distribution formed on the illumination pupil, on the illumination pupil or on a plane optically conjugate with the illumination pupil,

wherein the first step comprises controlling the spatial light modulator, based on a result of measurement by the pupil distribution measuring step.

18. A device manufacturing method comprising:

an exposure step of transferring the predetermined pattern onto the photosensitive substrate to effect exposure thereof, using the exposure method as set forth in claim 16 or 17;

a development step of developing the photosensitive substrate on which the predetermined pattern is transferred, to form a mask layer of a shape corresponding to the predetermined pattern on a surface of the photosensitive substrate; and

a processing step of processing the surface of the photosensitive substrate through the mask layer.

19. A control method of a spatial light modulator having a plurality of optical elements arrayed two-dimensionally and being individually controllable, the control method being a method for controlling the spatial light modulator used in an illumination optical system which forms a predetermined light intensity distribution on an illumination pupil on the basis of light from a light source having traveled via the spatial light modulator and which illuminates an illumination target surface on the basis of the light having traveled via the illumination pupil,

the control method of the spatial light modulator comprising integrally controlling postures of a group of optical elements according to a shape of the predetermined light intensity distribution formed on the illumination pupil, out of the plurality of optical elements of the spatial light modulator.

20. The control method of the spatial light modulator according to claim 19, wherein the group of optical elements have a plurality of optical elements adjacent to each other.

21. The control method of the spatial light modulator according to claim 20, wherein light having traveled via the plurality of optical elements adjacent to each other is directed toward an edge region of a contour of the predetermined light intensity distribution formed on the illumination pupil.

22. The control method of the spatial light modulator according to any one of claims 19 to 21, comprising measuring the predetermined light intensity distribution formed on the illumination pupil, on the illumination pupil or on a plane optically conjugate with the illumination pupil to acquire a result of measurement, and controlling the spatial light modulator, based on the result of measurement.

23. A program for letting a computer execute a specific process for controlling a spatial light modulator having a plurality of optical elements arrayed two-dimensionally and being individually controllable,
wherein the computer is made to execute the control method as set forth in any one of claims 19 to 22.

24. A computer-readable information recording medium in which the program as set forth in claim 23 is recorded.

25. A spatial light modulating device comprising a spatial light modulator having a plurality of optical elements arrayed two-dimensionally and being individually controllable, and a control unit for controlling the plurality of optical elements, the spatial light modulating device being used in an illumination optical system which forms a predetermined light intensity distribution on an illumination pupil on the basis of light from a light source having traveled via the spatial light modulator and which illuminates an illumination target surface on the basis of light having traveled via the illumination pupil,
wherein the control unit integrally controls postures of a group of optical elements according to a shape of the predetermined light intensity distribution formed on the illumination pupil, out of the plurality of optical elements of the spatial light modulator.

26. The spatial light modulating device according to claim 25, wherein the group of optical elements have a plurality of optical elements adjacent to each other.

27. The spatial light modulating device according to claim 26, wherein light having traveled via the plurality of optical elements adjacent to each other is directed toward an edge region of a contour of the predetermined light intensity distribution formed on the illumination pupil.

# Fig.1

# Fig.2

*Fig.3*

# Fig.4

# Fig.5

LIGHT INTENSITY

*Fig.6*

**Fig.7**

# Fig.8

# Fig.9

```
                    ┌─────────────┐
                    │    START    │
                    └──────┬──────┘
                           │
                           ▼
              ┌──────────────────────────┐
              │ DEPOSIT METAL FILM ON WAFER │────── S40
              └──────────────┬───────────┘
                             │
                             ▼
              ┌──────────────────────────┐
              │  APPLY PHOTORESIST ONTO   │────── S42
              │   DEPOSITED METAL FILM    │
              └──────────────┬───────────┘
                             │
                             ▼
        ┌───────────────────────────────────────┐
        │ TRANSFER IMAGE OF PATTERN FORMED ON MASK, │────── S44
        │   INTO EACH SHOT AREA ON WAFER,           │
        │     USING EXPOSURE APPARATUS              │
        └─────────────────┬─────────────────────┘
                          │
                          ▼
              ┌──────────────────────────┐
              │   DEVELOP PHOTORESIST     │────── S46
              └──────────────┬───────────┘
                             │
                             ▼
              ┌──────────────────────────┐
              │  PERFORM ETCHING OF WAFER, │────── S48
              │  USING RESIST PATTERN AS MASK │
              └──────────────┬───────────┘
                             │
                             ▼
                    ┌─────────────┐
                    │  NEXT STEP  │
                    └─────────────┘
```

# Fig.10

```
        ┌─────────┐
        │  START  │
        └────┬────┘
             │
             ▼
   ┌──────────────────────┐
   │ PATTERN FORMING STEP  │────── S50
   └──────────┬───────────┘
              │
              ▼
   ┌──────────────────────────┐
   │ COLOR FILTER FORMING STEP │────── S52
   └───────────┬──────────────┘
               │
               ▼
   ┌──────────────────────┐
   │  CELL ASSEMBLY STEP   │────── S54
   └──────────┬───────────┘
              │
              ▼
   ┌───────────────────────┐
   │ MODULE ASSEMBLY STEP   │────── S56
   └───────────┬───────────┘
               │
               ▼
         ┌─────────┐
         │   END   │
         └─────────┘
```

## INTERNATIONAL SEARCH REPORT

| International application No. |
| --- |
| PCT/JP2008/070000 |

A. CLASSIFICATION OF SUBJECT MATTER
*H01L21/027*(2006.01)i, *G02B19/00*(2006.01)i, *G02B26/08*(2006.01)i, *G03F7/20*(2006.01)i

According to International Patent Classification (IPC) or to both national classification and IPC

B. FIELDS SEARCHED

Minimum documentation searched (classification system followed by classification symbols)
H01L21/027, G02B26/08, G03F7/20

Documentation searched other than minimum documentation to the extent that such documents are included in the fields searched
Jitsuyo Shinan Koho          1922-1996   Jitsuyo Shinan Toroku Koho   1996-2009
Kokai Jitsuyo Shinan Koho    1971-2009   Toroku Jitsuyo Shinan Koho   1994-2009

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
| --- | --- | --- |
| X<br><br>Y | JP 2003-022967 A  (ASML NETHERLANDS B.V.),<br>24 January, 2003 (24.01.03),<br>Full text; all drawings (particularly, 1st<br>example; Figs. 3, 5)<br>& EP 1262836 A1          & US 2003/038225 A1<br>& KR 2002092207 A        & US 6737662 B2<br>& US 2004/108467 A1      & US 7015491 B2 | 1-5,7-13,<br>15-27<br>6,14 |
| Y | JP 2002-353105 A  (NIKON CORP.),<br>06 December, 2002 (06.12.02),<br>Full text; all drawings (particularly, Fig. 1)<br>(Family: none) | 6,14 |
| A | JP 08-313842 A  (NIKON CORP.),<br>29 November, 1996 (29.11.96),<br>Full text; all drawings<br>(Family: none) | 1-27 |

☒ Further documents are listed in the continuation of Box C.   ☐ See patent family annex.

| * Special categories of cited documents: | "T" later document published after the international filing date or priority date and not in conflict with the application but cited to understand the principle or theory underlying the invention |
| --- | --- |
| "A" document defining the general state of the art which is not considered   to be of particular relevance | |
| "E" earlier application or patent but published on or after the international filing date | "X" document of particular relevance; the claimed invention cannot be considered novel or cannot be considered to involve an inventive step when the document is taken alone |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search<br>15 January, 2009 (15.01.09) | Date of mailing of the international search report<br>27 January, 2009 (27.01.09) |
| --- | --- |
| Name and mailing address of the ISA/<br>Japanese Patent Office | Authorized officer |
| Facsimile No. | Telephone No. |

Form PCT/ISA/210 (second sheet) (April 2007)

<table>
<tr><td colspan="2">**INTERNATIONAL SEARCH REPORT**</td><td>International application No.<br>PCT/JP2008/070000</td></tr>
</table>

C (Continuation).   DOCUMENTS CONSIDERED TO BE RELEVANT

| Category* | Citation of document, with indication, where appropriate, of the relevant passages | Relevant to claim No. |
|---|---|---|
| A | JP 2006-019753 A  (ASML HOLDING N.V.),<br>19 January, 2006 (19.01.06),<br>Full text; all drawings<br>& US 2006/001890 A1 | 1-27 |

Form PCT/ISA/210 (continuation of second sheet) (April 2007)

**REFERENCES CITED IN THE DESCRIPTION**

**Patent documents cited in the description**

- JP 2002353105 A
- US 6913373 B
- US 6741394 B
- JP 2006054328 A
- JP 2003022967 A
- US 20030038225 A
- JP 10503300 W
- EP 779530 A
- JP 2004078136 A
- US 6900915 B
- JP 2006524349 W
- US 7095546 B
- JP 2006113437 A
- JP 6281869 A
- US 5312513 A

- JP 2004520618 W
- US 6885493 B
- JP 2006513442 W
- US 6891655 B
- JP 2005524112 W
- US 20050095749 A
- US 5229872 A
- JP 2004304135 A
- WO 2006080285 A
- US 20070296936 A
- WO 9949504 A
- JP 6124873 A
- JP 10303114 A
- US 20060170901 A
- US 20070146676 A